## Europäisches Patentamt
## European Patent Office
## Office européen des brevets

(11) Publication number: **0 084 525**
**B1**

(12) **EUROPEAN PATENT SPECIFICATION**

(45) Date of publication of patent specification: **18.09.85**

(51) Int. Cl.⁴: **C 23 C 16/40, B 23 B 27/14**

(21) Application number: **83850001.5**

(22) Date of filing: **11.01.83**

(54) Method of making a coated cemented carbide body and resulting body.

(30) Priority: **26.01.82 SE 8200400**

(43) Date of publication of application:
**27.07.83 Bulletin 83/30**

(45) Publication of the grant of the patent:
**18.09.85 Bulletin 85/38**

(84) Designated Contracting States:
**DE FR GB IT**

(56) References cited:
**FR-A-2 393 852**
**FR-A-2 422 728**

(73) Proprietor: **Santrade Ltd.**
**Alpenquai 12 P.O. Box 321**
**CH-6002 Luzern (CH)**

(72) Inventor: **Lindström, Jan Nils**
**Klyvningsvägen 31**
**S-145 60 Norsborg (SE)**
Inventor: **Smith, Ulf Karl Helmer**
**Sofiebergsvägen 47B**
**S-141 42 Huddinge (SE)**

(74) Representative: **Östlund, Alf Olof Anders et al**
**Sandvik AB Central Service Patents and**
**Licences**
**S-811 81 Sandviken (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method of producing thin, even and extremely wear resistant surface layers of ceramic oxide, preferably aluminium oxide, on cemented carbide substrates. The latter may be uncoated or have coatings produced in other processes or in process steps immediately preceding the process step described hereinbelow.

It is known that the wear resistance of pressed and sintered cemented carbide bodies, as for example, inserts for chipforming machining, can be increased considerably by applying hard surface layers. In particular, coatings of metal carbides, metal nitrides or metal oxides have been applied as thin layers (having, for example, a thickness between 0.1 to 20 μm) on the cemented carbide core or the substrate. It is also known that further advantages can be reached in certain cases by using a thin coating composed of two or more different layers applied on top of each other, for example, the use of a metal carbide or nitride as an intermediate layer below an outer ceramic layer. Aluminium oxide ($Al_2O_3$) and zirconium oxide ($ZrO_2$) are examples of such ceramic surface layers.

The main method of applying the surface coatings is the CVD-technique or "Chemical Vapor Deposition", in which the coatings are deposited on a hot substrate by reaction between gaseous components. For the production of ceramic oxide coatings, the most common chemical vapor deposition system which has been employed utilizes a hydrolysis reaction of a metal halide to form the specific ceramic oxide, the metal halide being either evaporated directly or formed by the reaction between the specific metal and halogen or hydrogen halide. The hydrolysis reaction is performed with water vapor, which is either evaporated directly or formed in situ by the reaction between hydrogen and carbon dioxide or oxygen. For the production of aluminium oxide coatings, aluminium chloride is hydrolyzed.

The formation of an aluminium oxide coating depends, among other things, upon the diffusion of species from the substrate and/or the gas phase. The relationship between the various diffusion, nucleation and growth mechanisms which govern the formation of a coating are of a very critical nature and are often difficult to govern in the desired direction. Thus, it can be extremely difficult to produce relatively thick coatings of aluminium oxide using known processes if the coatings are to be uniformly distributed around the coated body. If one wants to use the known processes (see for example Swedish pat. 357.984, US Pat. 3.736.107, US Pat. 3.836.392 and Swedish Pat. 406.090) in order to produce such coatings, drastic modifications of the coating conditions are needed. However, such modifications often give rise to conditions in the process, which are harmful to the substrate or lead to significant reduction of production capacity.

The present invention now makes it possible to produce cemented carbide bodies having ceramic oxide, preferably aluminium oxide, coatings of uniform thickness around the individual body and with, among other things, thicknesses in ranges of interest in cutting applications. The coatings pertaining to the invention can be applied to previously coated as well as uncoated cemented carbide substrates, e.g., substrates containing at least one carbide in addition to the binder metal. The coatings can also form surface or intermediate layers in multiple coatings of various kinds. The coating can advantageously be deposited on intermediate layers of wear resistant carbides, nitrides, carbonitrides, oxides, borides or combinations and/or mixture of such compounds, applied in the form of one or more successive layers. The invention can also be of advantage in the deposition of coatings on ceramic bodies.

The carbides, nitrides, oxides and borides mentioned above, as well as combinations thereof may be those of one or several of the elements Ti, Zr, Hf, V, Nb, Ta, Cr, Mo, W, Si and, where applicable, B.

Layers of titanium carbide, nitride and/or carbonitride are especially suited as intermediate layers.

When the aluminium oxide coating is deposited, a gas consisting of one or more halides of aluminium and heated to a high temperature is brought in contact with the substrate. The EP—A—0045291 describes that thin, even aluminium oxide coatings and a great increase of the growth rate of the aluminium oxide layer are obtained by supplying a controlled amount of sulphur, selenium and/or tellurium to the substrate during the deposition.

It has now quite surprisingly been found that phosphorus, arsenic, antimony and/or bismuth supplied to the substrate during the deposition, have a similar effect.

A distinct feature of the invention is that a controlled amount of phosphorus, arsenic, antimony and/or bismuth is supplied to the substrate during the deposition. The dopant is preferably phosphorus and the process of the present invention will be described below with reference to phosphorus (unless otherwise indicated) although it will be understood that it is equally applicable to arsenic, antimony and bismuth and mixtures of these dopants. A suitable form for this additional supply of the dopant is a gas with molecules containing the elements mentioned. According to the present invention, phosphorus, arsenic, antimony and/or bismuth are generally introduced in the process in compound form. However, in order that the effects encompassed by the invention be realized, it is important that the compound used for the supply of phosphorus is not only of adequate purity but also free from elements which have a detrimental effect on the process itself or on the product made by means of the process. The phosphorus containing component (or components) participating in the process should therefore be of such a composition that it (they) does not contain any foreign elements which are harmful to the process. As known in the CVD-art, silicon is an element which is considered harmful. Other elements or compounds which would also interfere with the straight forward manner of the process of the present invention should also be avoided. An example of a compound which satisfies these requirements and which permits a carefully controlled and optimized introduction into the gas mixture used in the process is phosphorus chloride ($PCl_3$). Phosphine ($PH_3$) can also be used.

When phosphorus (arsenic, antimony, bismuth or mixtures thereof) is introduced into the process in accordance with the present invention, a large increase in the growth rate of the aluminium oxide coating is quite surprisingly obtained in such a way that requirements regarding a uniformly thick coating of aluminium oxide around the coated body are met. A coating produced according to the present invention has quite surprisingly, such mechanical, physical and chemical properties as to provide the coated body with a performance in technologically interesting applications which clearly exceeds the performance of products manufactured by means of similar processes not using the method which characterizes the present invention. If, on the other hand, the process described by the invention is adjusted with respect to coating thickness and thickness distribution in such a manner that the finished product is more or less identical with products manufactured by means of known processes, quite surprisingly, a product is obtained having a performance which is in no way inferior to that of the latter products.

These unexpected effects of the invention can be observed quite easily, among other things in the technologically important areas of cutting and wear. In all those instances where excessive coating thicknesses around edges and corners are disadvantages, a considerably improved performance is obtained when products are used that have been manufactured according to the process described by the present invention. The explanation as to why the invention leads to such a drastic modification of the growth mechanisms of the aluminium oxide coating is of a theoretically complex nature and is at present not quite clear, but it can be mentioned that the effects caused by the process as described by the invention are remarkably similar to what is to be expected from such chemical processes which depend upon catalysts and surface catalyst poisoners.

In addition to increasing the rate of production of coatings, the increase in the rate of deposition is of direct benefit for the quality of the coating in that an increased rate reduces the period of time during which coating and substrate are treated at a high temperature. This reduces the probability of detrimental changes in the structure and composition of coating and substrate and intermediate zone respectively which might occur as a result of prolonged exposure to higher temperatures. As has been indicated above, the principal method of producing an aluminium oxide coating is, according to the invention, by means of CVD-techniques in combination with an addition of phosphorus. This applies to substrates consisting exclusively of hard materials (together with a binder metal where applicable) as well as for substrates already having one or more coatings.

If necessary, the cemented carbide substrate may have a surface region enriched with respect to the so-called gamma phase. This holds true for those instances when additional layers are to be added on to the aluminium oxide coating produced according to the invention. A CVD-process made according to the invention can be done in a step separate from the deposition of the other layers but should preferably be made successively in the same apparatus so that well-defined surfaces are available for each deposition step.

An amount of methane from about 0.5 to about 90 vol.% of the total amount of the supplied gas may be added to the gas for the $Al_2O_3$ coating step so that at least a substantial portion, often at least about 85%, of the $Al_2O_3$ is in the kappa form. The methane thus acts in the same manner as the dopant disclosed in commonly assigned U.S. Patent 4.180.400 and may be added in conjunction with the phosphorus dopant or alone in those instances where the kappa form is desired and uneven $Al_2O_3$ layers are not critical.

The aluminium oxide coating is typically 0.1 — 20 µm and preferably 0.3 — 9 µm. The thicknesses of the intermediate or of the successive layers, on top of as well as beneath the aluminium oxide layer under consideration, normally fall in the range of 0.1 — 20 µm, that is, they are of the same order of magnitude.

In those instances when intermediate coatings of wear-resistant carbides, nitrides, carbonitrides and borides as well as combinations thereof are applied, the thickness of the aluminium oxide layer is usually 0.1 — 15 µm.

When higher amounts of phosphorus are added, about 0.05 — 1 vol.% $PCl_3$, intermediate layers are obtained beneath and/or within the outer ceramic layer (e.g. $Al_2O_3$). The intermediate layers contain phosphorus and metal diffused from the substrate e.g. the binder phase of the substrate. Such an intermediate layer can consist of $Co_2P$. The thickness is about 0.1 — 3 µm. Phosphorus may occasionally diffuse into the cemented carbide substrate.

Further, when phosphorus is added, the outer layer zone can be enriched in metal diffused from the binder phase of the substrate, e.g. Co.

The methods used in producing cemented carbide bodies and ceramic bodies in accordance with the invention are illustrated by means of Examples 1 to 6 below and by the Figures in which:

Fig. 1 is a sketch of production apparatus useful in coating a substrate with suitable metal carbide, nitride and/or carbonitride;

Fig. 2 is a sketch of equipment useful in coating a substrate with aluminium oxide.

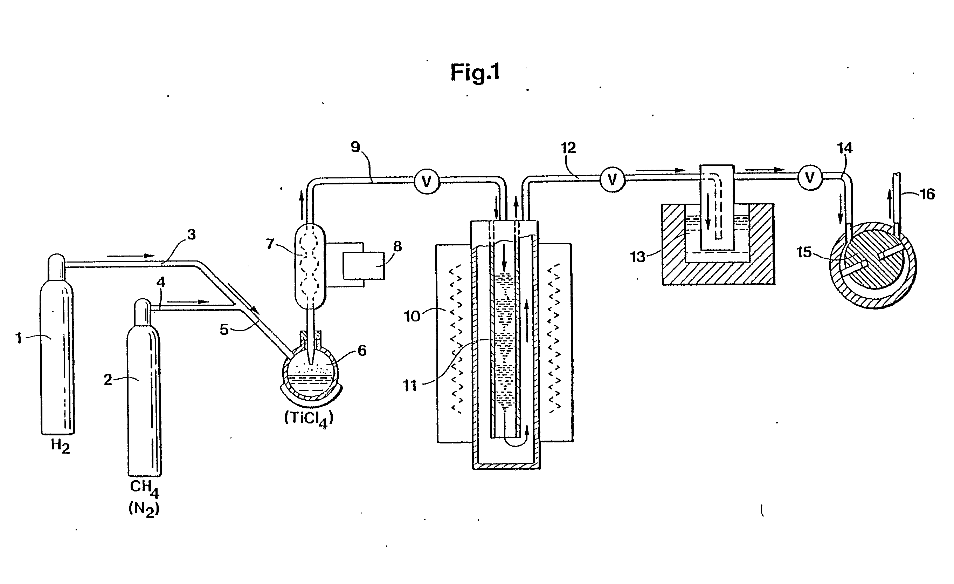

The equipment shown in Fig. 1 consists of sources of gas, for example gas tubes 1 and 2 for the supply of hydrogen, methane and/or nitrogen. The conduits 3 and 4 each join a source of gas with conduit No. 5 through which the gas mixture is transported to a vessel 6 where a metal halide, e.g., $TiCl_4$, is heated so as to give off an adequate amount of vapor. The mixture of these gases is then fed to the reactor 11 via a common conduit 9. The gas mixture thereby passes a heat exchanger 7 which is controlled by a thermostat 8 so that the amount of $TiCl_4$, in the gas mixture is held at the correct level. The substrate to be coated is placed in the reactor 11, the latter being heated by an oven 10. The gas is sucked out of the reactor via a conduit 12 equipped with a valve and a cold trap 13. The system is evacuated via conduit 14 by means of a vacuum pump 15 with an exhaust pipe 16.

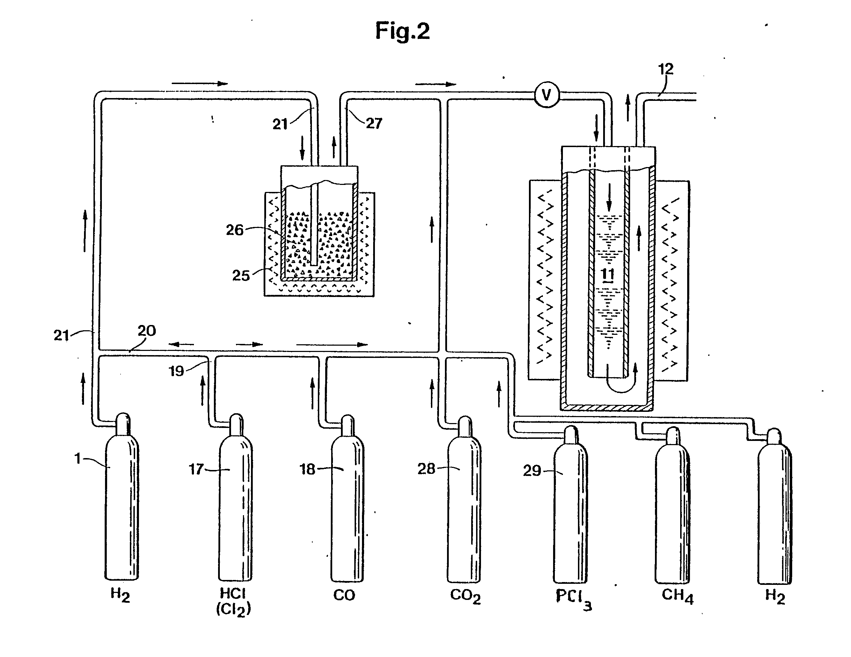

The equipment outlined in Fig. 2 illustrates the use of a separate reactor 25 for the chlorination of Al, the latter being in the form of e.g., grains or chips 26. In order to obtain this chlorination, hydrogen from a source of gas 1 is mixed with chlorine or hydrochloric acid via conduits 19 and 20, the latter coming from the source 17. The mixture is then brought to the chlorination reactor via a conduit 21.

The gas mixture from the chlorination reactor 25 is then further mixed with hydrogen, as well as with carbon monoxide and carbon dioxide from the sources 18 and 28 respectively. This gas mixture is then routed to the deposition reactor 11 via the conduit 27 which is equipped with a valve. (The systems for purifying the gases have been left out in the Figures).

The deposition of aluminium oxide can thus be performed by means of a process namely hydrolysis of an aluminium halide, viz. preferably a chloride ($AlCl_3$), using water vapor (oxygen).

As indicated above, the aluminium halide can be produced in the form of a gas either by evaporation of the solid or liquid phase or by reacting metallic aluminium with chlorine or hydrochlorine gas 26. The water vapor can be added to the gas phase either by evaporation of water or, preferably, by reacting hydrogen with carbon dioxide 28. Phosphorus can be added to the gas phase by adding preferably gases or gas mixtures 29 containing phosphorus or compounds of phosphorus. Preferably the addition is made in the form of phosphorus chloride ($PCl_3$), which is introduced throughout the whole process or part of the process. Phosphorus compounds may also be generated in the reactor in situ.

The reactants are fed into the reactor 11, in which the bodies which are to be coated have been placed. The bodies can be heated either directly by means of induction heating or indirectly by heating e.g. supporting plates or the reactor itself by e.g., resistance heating 10. The deposition temperature can be in the range 700°C to 1200°C, but preferably in the range 950°C to 1150°C.

The concentrations of aluminium chloride vapor in the gaseous mixture of reactants should preferably be over stoichiometric with respect to the water vapor. The concentration of the phosphorus-, arsenic-, antimony- or bismuth-containing gas should be in the range 0.003 — 1, preferably in the range 0.02 — 0.3 vol.% per atom of P, As, Sb, Bi in the gas molecule as referred to the total gas volume being brought into the reactor.

It is also important that the concentrations of carbon dioxide be monitored carefully. The amount of phosphorus containing gas recommended above refers to the case of roughly stoichiometric proportions of carbon dioxide and aluminium chloride in the gas entering the reactor at a temperature of 1000°C and 6 kPa. The total pressure of the gaseous phase may be in the range of 0.1 — 100 kPa, but should preferably be in the range 1 — 30 kPa.

It is often easy to demonstrate the presence of phosphorus in a coating or in adjacent parts of the substrate including any intermediate layer by means of microprobe analysis. More sophisticated methods of analysis, e.g. ion-microprobe, proton induced x-ray emission spectroscopy or Auger analysis can be used to detect even extremely small amounts of phosphorus or effects caused by the presence of phosphorus. Excellent performance has been observed when the coating and/or the surface of the substrate have contained minor amounts, e.g., more than 0.1 weight—% phosphorus, arsenic, antimony or bismuth. It will be understood that significant amounts of these elements need not be present and could adversely affect the use of the coated bodies in certain applications, i.e., wear-resistant cutting inserts.

A few examples will be given below in order to illustrate various conditions which can be used to produce aluminium oxide coatings according to the invention. Results from tests using bodies coated in such a manner will also be given.

Finally, it deserves to be emphasized that within the scope of the invention one can find coatings consisting of other ceramic oxides than aluminium oxide as well as other wear resistant compounds containing ceramic oxides such as solid solutions etc. which can be produced from the gaseous phase in ways similar to what has been described above. Improved performance due to an optimized addition of phosphorus has thus been observed in these cases as well.

The invention is additionally illustrated in connection with the following Examples which are to be considered as illustrative of the present invention. It should be understood, however, that the invention is not limited to the specific details of the Examples.

### Example 1
*Specimen group (a)*

Coating with an intermediate layer of TiC was performed in a reactor, the essential parts of which were made of "Inconel" alloy.

In this reactor vessel 3000 sintered cemented carbide inserts are heated to 1020°C. The inserts to be coated contained WC 86% (by weight), cubic carbides (TiC, TaC, NbC) 9%, balance Co.

The inserts are placed on nets providing good contact with the surrounding gas. The gas, which consisted of a mixture containing 4% $CH_4$, 4% $TiCl_4$ and 92% $H_2$, by vol., manufactured in a normal way, is brought to the reactor in one single conduit. The pressure in the reactor is maintained at 7 kPa by sucking out of the gas from the reaction vessel by means of a vacuum pump protected from corrosive reaction products (for instance HCl) by the help of a cooling trap with liquid nitrogen situated ahead of the pump. In this way a linear gas flow rate of 1 m/sec is obtained in the charge.

The treatment went on for 7 hours.

As a result of the treatment, a fine-grained, tight TiC-layer of about 4 μm thickness is obtained. The amount of embrittling η-phase, because of decarburizing, will be very small.

The 3000 inserts are treated in the same apparatus as the one described, the gas supply being 91% $H_2$, 5% $CO_2$, 2% HCl, 2% $AlCl_3$, 0.07% $PCl_3$.

The temperature of the substratum is 1030° and the pressure 7 kPa. A linear gas flow rate of 3 m/sec is used. After a coating time of 3 hours, a 1 μm thick layer of $Al_2O_3$ has been formed on the TiC-coated hard metal inserts. The binding between the $Al_2O_3$ layer and TiC layer is good and almost no embrittling η-phase has been formed in the boundary layer, cemented carbide-TiC-layer.

Small amounts of $Co_2P$ beneath and/or within the $Al_2O_3$ layer have been identified optically and by X-ray diffraction. Reducing the amount of $PCl_3$ to only about 0.035 vol.% implies that no $Co_2P$ is formed.

*Specimen group (b)*

Inserts coated without $PCl_3$ during similar conditions but for 8 h obtain 1 μm $Al_2O_3$. On the edges of the inserts, however, a coating thickness of 2—8 μm $Al_2O_3$ is obtained.

*Comparative test*

In a comparative intermittent finishing operation (work piece Steel SIS (Swedish International Standard) 2541: analyses: C=0.36, Si=0.30, Mn=0.7, S=0.03, Cr=1.4, Ni=1.4, Mo=0.2%, HB (hardness) 290 (work piece diam. 160—140 mm, length 700 mm, with one milled longitudinal slot, width 25 mm) the following test is run:

| | |
|---|---|
| Cutting speed: | 300 m/min |
| Depth of cut: | 1.0 mm |
| Feed: | 0.15 mm |

The operation is performed as paired comparative tests of inserts according to the invention (a) and inserts according to (b), resulting in the following relative tool life values:

(a) 1.0
(b) 0.5

## Example 2

Inserts are produced in a similar manner as described in Example 1. The only difference is that $PH_3$ is used instead of $PCl_3$. Similar results are obtained.

## Example 3

Inserts are produced in a similar manner as described in Example 1. However, 0.1 vol.% $PCl_3$ is used resulting in an intermediate layer (about 1 μm) of $Co_2P$ beneath the $Al_2O_3$ layer.

## Example 4

Inserts are produced comprising a surface zone of gamma phase using the following method.

The substrate is chosen in accordance with Example 1.

The inserts are treated in a nitrogen atmosphere (pressure 5 kPa) at 1410°C for 30 minutes (graphite in the furnace), whereafter the inserts are cooled. Grains of gamma phase have been enriched in the surface zone of the inserts to a 0.5 — 2 μm thick continuous zone.

Coating with $Al_2O_3$ is performed in accordance with Example 1 but a very thin TiC-layer (0.2 μm) is positioned immediately under the $Al_2O_3$-layer.

The TiC coating is deposited in accordance with Example 1 but the duration of the deposition is decreased to 1 h.

No embrittling η-phase can be detected in the surface zones. The inserts have very even layers of $Al_2O_3$ all over the coated objects.

## Example 5

Inserts are produced as in Example 1 (a) but 0.05% $AsCl_3$ is added to the gas mixture (the amount of $PCl_3$ is reduced accordingly).

## Example 6

Ceramic inserts are coated in accordance with Example 1. Remarkably evenly distributed layers of $Al_2O_3$ are obtained.

The principles, preferred embodiments and modes of operation of the present invention have been described in the foregoing specification. The invention which is intended to be protected herein, however, is not to be construed as limited to the particular forms disclosed, since these are to be regarded as illustrative rather than restrictive.

**Claims**

1. Method of making a body comprising a substrate or one or more cemented carbides or ceramics and at least one thin, wear resistant surface layer consisting of ceramic oxide, preferably aluminium oxide, in which the substrate is contacted with a gas containing one or more halides of metals forming the ceramic oxide and a hydrolyzing and/or oxidizing agent at high temperature, to form the ceramic oxide layer, characterized in that an amount of phosphorus, arsenic, antimony and/or bismuth is added to the gas.

2. Method according to claim 1, wherein the added amount of phosphorus, arsenic, antimony and/or bismuth is from about 0.003 to 1% by volume of the total gas volume.

3. Method according to claim 2, wherein the added amount of phosphorus, arsenic, antimony and/or bismuth is from about 0.02 to 0.3% by volume of the total gas volume.

4. Coated body containing at least one metal carbide or ceramic compound on which body there is applied at least one thin wear resistant surface layer of ceramic oxide, preferably aluminium oxide characterized in that said layer and/or the surface zone of the substrate contains minor amounts of phosphorus, arsenic, antimony and/or bismuth.

5. Coated body according to claim 4 characterized in an intermediate layer beneath and/or within the surface layer, said intermediate layer containing phosphorus and metal diffused from the substrate.

6. Coated body according to claim 5 characterized in that the intermediate layer consists of $Co_2P$.

7. Coated body according to claims 5—6 characterized in that the intermediate layer is about 0.1 — 3 µm thick.

8. Coated body according to any of the preceding claims 4—7 characterized in that at least one thin additional layer of wear resistant carbide, nitride, carbonitride and/or boride of one or more of the elements Ti, Zr, Hf, V, Nb, Ta, Cr, Mo, W, Si and/or B, is applied between the ceramic oxide, preferably aluminium oxide and the substrate.

## Patentansprüche

1. Verfahren zur Herstellung eines Formkörpers mit einem Substrat eines oder mehrerer Sinter carbide oder keramischer Materialien und wenigstens einer dünnen verschleißfesten Oberflächenschicht aus keramischem Oxid, vorzugsweise Aluminiumoxid, bei dem das Substrat mit einem Gas, das ein oder mehrere das keramische Oxid bildende Metallhalogenide und ein hydrolysier endes und/oder oxidierendes Mittel enthält, bei hoher Temperatur unter Bildung der keramischen Oxidschicht in Berührung gebracht wird, dadurch gekennzeichnet, daß dem Gas eine Menge an Phosphor, Arsen, Antimon und/oder Wismut zugesetzt wird.

2. Verfahren nach Anspruch 1, bei dem die zugesetzte Menge an Phosphor, Arsen, Antimon und/oder Wismut bei etwa 0,003 bis 1 Vol.—% des gesamten Gasvolumens liegt.

3. Verfahren nach Anspruch 2, bei dem die zugesetzte Menge an Phosphor, Arsen, Antimon und/oder Wismut bei etwa 0,02 bis 0,3 Vol.-% des gesamten Gasvolumens liegt.

4. Beschichteter Formkörper, der wenigstens ein Metallcarbid oder wenigstens eine keramische Verbindung enthält und auf dem wenigstens eine dünne verschleißfeste Oberflächenschicht von keramischem Oxid auf vorzugsweise Aluminiumoxid, aufgebracht ist, dadurch gekennzeichnet, daß diese Schicht und/oder die Oberflächenzone des Substrates kleinere Mengen an Phosphor, Arsen, Antimon und/oder Wismut enthalten.

5. Beschichteter Formkörper nach Anspruch 4, gekennzeichnet durch eine Zwischenschicht unter und/oder in der Oberflächenschicht, wobei diese Zwischenschicht Phosphor und aus dem Substrat diffundiertes Metall enthält.

6. Beschichteter Formkörper nach Anspruch 5, dadurch gekennzeichnet, daß die Zwischenschicht aus $Co_2P$ besteht.

7. Beschichteter Formkörper nach den Ansprüchen 5—6, dadurch gekennzeichnet, daß die Zwischenschicht etwa 0,1 bis 3 µm dick ist.

8. Beschichteter Formkörper nach einem der vorausgehenden Ansprüche 4 bis 7, dadurch gekennzeichnet, daß wenigstens eine dünne zusätzliche Schicht aus verschleißfestem Carbid, Nitrid, Carbonitrid und/oder Borid eines oder mehrerer der Elemente Ti, Zr, Hf, V, Nb, Ta, Cr, Mo, W, Si und/oder B zwischen der keramischen Oxidschicht, vorzugsweise Aluminiumoxidschicht, und dem Substrat aufgebracht ist.

## Revendications

1. Procédé pour réaliser un corps comprenant un substrat constitué d'un ou plus d'un carbures ou matières céramiques frittés et au moins une couche mince de surface résistant à l'usure et constituée d'un oxyde céramique, de préférence de l'oxyde d'aluminium, dans lequel le substrat est mis en contact avec un gaz contenant un ou plus d'un halogénures de métaux formant l'oxyde céramique et un agent hydrolysant et/ou oxydant à haute température, pour former la couche d'oxyde céramique, caractérisé en ce qu'une quantité de phosphore, d'arsenic d'antimoine et/ou de bismuth est ajoutée au gaz.

2. Procédé selon la revendication 1, dans lequel la quantité ajoutée de phosphore, d'arsenic, d'antimoine et/ou de bismuth constitue de 0,003 à 1% en volume du volume total du gaz.

3. Procédé selon la revendication 2, dans lequel la quantité ajoutée de phosphore, d'arsenic, d'antimoine et/ou de bismuth constitue de 0,02 à 0,3% en volume du volume total du gaz.

4. Corps revêtu contenant au moins un carbure métallique ou un composé céramique, au moins une couche mince de surface résistant à l'usure et constituée en oxyde céramique étant appliquée sur ledit corps, cet oxyde étant de préférence de l'oxyde d'aluminium, caractérisé en ce que ladite couche et/ou la zone de surface du substrat contiennent des faibles quantités de phosphore, d'arsenic, d'antimoine et/ou de bismuth.

5. Corps revêtu selon la revendication 4, caractérisé par une couche intermédiaire située sous et/ou dans la couche de surface, ladite couche intermédiaire contenant du phosphore et du métal de diffusion à partir du substrat.

6. Corps revêtu selon la revendication 5, caractérisé en ce que la couche intermédiaire est en $Co_2P$.

7. Corps revêtu selon l'une des revendications 5 et 6, caractérisé en ce que la couche intermédiaire a une épaisseur d'environ 0,1 à 3 microns.

8. Corps revêtu selon l'une quelconque des revendications précédentes 4 à 7, caractérisé en ce qu'au moins une couche mince additionnelle résistant à l'usure et constituée d'un carbure, d'un nitrure, d'un carbonitrure et/ou d'un borure de l'un ou plus d'un des éléments Ti, Zr, Hf, V, Nb, Ta, Cr, Mo, W, Si et/ou B, est appliquée entre la couche d'oxyde céramique, de préférence en oxyde d'aluminium, et le substrat.

Fig.1

# Fig.2

0 084 525